# EUROPEAN PATENT APPLICATION

(11) **EP 2 693 421 A1**
(43) Date of publication of application: **05.02.2014**
(21) Application number: 13174112.6
(22) Date of filing: 27.06.2013
(51) Int. Cl.: G09G 3/00, G06F 1/28

(54) **Display apparatus and method of detecting error from voltage thereof**

(30) Priority: 01.08.2012 KR 20120084525
(71) Applicant: Samsung Electronics Co., Ltd, Gyeonggi-do 443-742 (KR)
(72) Inventor: Lee, Sang-eun, Seoul (KR); Choe, Ju-hyun, Gyeonggi-do (KR); Kim, Hyun-ho, Seoul (KR)
(74) Representative: Walaski, Jan Filip

(57) **Abstract**

A display apparatus and a method for detecting a voltage error thereof, include a display unit which displays an image, a voltage supply which supplies a voltage to respective elements of the display apparatus, a detector which monitors a plurality of voltages supplied to the respective elements of the display apparatus and detects an error occurring from at least one of the plurality of voltages, and a controller which determines a location where an error has occurred if the error has occurred from at least one of the plurality of voltages according to a detection result of the detector. Thus, the display apparatus and method thereof determine whether a voltage error is present and determine the location of one or more errors without difficulty using a circuit for performing the self diagnosis.

## Description

The present invention relates to a display apparatus and a method of detecting an error from a voltage thereof. More particularly, the exemplary embodiments disclosed herein relate to a display apparatus and a method for detecting an error from a voltage thereof which detects an error of a voltage supplied to respective elements of the display apparatus.

A display apparatus such as a TV includes a power supply such as a switching mode power supply (SMPS) to supply a voltage to respective elements of the display apparatus. The display apparatus includes a plurality of various elements, to which the voltage supply supplies a proper amount of voltage.

If any error occurs from a part of the plurality of voltages supplied as above, the concerned element cannot receive voltage normally and thus may not perform its function properly.

However, in the case of a conventional display apparatus, if an error occurs from the voltage supplied to a part of the plurality of elements, finding the location where the error has occurred is difficult.

Accordingly, the entire display apparatus should inevitably be inspected and this may be inefficient and cause inconvenience. Further, unnecessary time and costs may be needed for analysis and servicing (A/S).

Additional aspects and/or advantages will be set forth in part in the description which follows and, in part, will be apparent from the description, or may be learned by practice of the invention.

The foregoing and/or other aspects may be achieved by providing a display apparatus including a display unit which displays an image thereon, a voltage supply which supplies a voltage to respective elements of the display apparatus, a detector which monitors a plurality of voltages supplied to the respective elements of the display apparatus and detects an error occurring from at least one of the plurality of voltages, and a controller which determines a location where an error has occurred if the error has occurred from at least one of the plurality of voltages according to a detection result of the detector.

The controller may control the display unit to display thereon a message showing the location where the voltage error has occurred.

The display apparatus may further include a plurality of resistors which is provided within or outside the detector and is connected to the plurality of voltages and divides the voltages.

The detector may include a first detector which detects power status (e.g., on and/or off) of the display apparatus.

The first detector may include a plurality of comparators which receives an operating voltage according to the power status and a first reference voltage, and a plurality of delay units which selectively receives an output value of the plurality of comparators.

The detector may include second and third detectors which compare the plurality of voltages with a preset reference voltage and detect a voltage error which occurs from at least one of the plurality of voltages.

The second detector may include a plurality of comparators which determines whether an input voltage is within a preset range, and the plurality of comparators may include a first comparator which receives one of the plurality of voltages and a second over reference voltage, and outputs a comparison result, and a second comparator which receives one of the plurality of voltages and a second under reference voltage and outputs a comparison result.

The third detector may include a plurality of comparators which determines whether an input voltage is within a preset range, and the plurality of comparators may include a third comparator which receives one of the plurality of divided voltages and a third reference voltage, and outputs a comparison result, and a fourth comparator which receives one of the plurality of divided voltages and a third reference voltage and outputs a comparison result.

The detector may have a preset error tolerance. The detector may further include a register which stores data according to a monitoring result of the plurality of voltages.

The detector may further include an interface which is provided between the register and the controller, and the controller may read data stored in the register through the interface to determine a location where the voltage error has occurred.

The monitoring of the plurality of voltages may be performed if at least one of the conditions, (i) a user's input for selecting a self-diagnosis of voltages, (ii) arrival of a preset diagnosis period and (iii) a power-on of the display apparatus, is satisfied.

The foregoing and/or other aspects may be achieved by providing a method of detecting an error from a voltage of a display apparatus including monitoring a plurality of voltages supplied by a voltage supply to respective elements of the display apparatus, detecting an error which occurs from at least one of the plurality of voltages, and determining a location where a voltage error has occurred if the error has occurred from at least one of the plurality of voltages according to the detection result.

The method may further include displaying a message showing the location where the voltage error has occurred.

The detecting the error may include comparing the plurality of voltages and a preset reference voltage, and detecting a voltage error which occurs from at least one of the plurality of voltages according to the comparison result.

The comparing may include determining whether the input voltage is within a preset range. The preset range may be determined by an error tolerance.

The method may further include storing data according to a monitoring result of the plurality of voltage. The method may further include resetting stored monitoring result data before the monitoring is begun.

The monitoring may be performed if at least one of (i) a user's input for selecting a self-diagnosis of voltages, (ii) arrival of a preset diagnosis period and (iii) a power-on of the display apparatus is satisfied.

The foregoing and/or other aspects may be achieved by providing a method of determining a location of a voltage error of a display apparatus including comparing a plurality of input voltages corresponding to respective elements of the display apparatus with at least one reference voltage, and determining a location where the voltage error has occurred when a result of the comparison indicates a voltage error corresponding to at least one of the elements of the display apparatus.

The comparing of the plurality of input voltages with the at least one reference voltage may include performing a first comparison between a first input voltage and a first reference voltage corresponding to a tolerance level, performing a second comparison between the first input voltage and a second reference voltage corresponding to the tolerance level, outputting a high or low state according to the results of the first and second comparisons; and determining a first input voltage error according to the output state.

The method of determining a location of a voltage error of a display apparatus may further include storing, in a register, result data corresponding to a result of the comparing; and reading, by a controller, the result data from the register to determine whether a voltage error has occurred in one or more elements of the display apparatus.

The above and/or other aspects will become apparent and more readily appreciated from the following description of the exemplary embodiments, taken in conjunction with the accompanying drawings, in which:
FIG. 1 is a block diagram of a display apparatus according to an embodiment;
FIG. 2 is a block diagram of a detector according to the embodiment;
FIG. 3 is a circuit diagram of the detector in FIG. 2;
FIG. 4 is a circuit diagram of a fourth comparator according to the embodiment;
FIG. 5 illustrates waveforms of an input/output signal of the fourth comparator;
FIG. 6 is a circuit diagram of a ninth comparator according to the embodiment;
FIG. 7 illustrates waveforms of an input/output signal of the ninth comparator;
FIG. 8 illustrates an error detecting operation according to the embodiment;
FIG. 9 illustrates a screen for setting a voltage diagnosis menu according to the embodiment;
FIG. 10 illustrates an example of a message showing a voltage diagnosis result according to the embodiment;
FIG. 11 illustrates a screen for setting a periodic voltage diagnosis according to the embodiment; and
FIG. 12 is a flowchart showing a method for detecting an error from a voltage of the display apparatus according to the embodiment.

Below, exemplary embodiments will be described in detail with reference to accompanying drawings so as to be easily realized by a person having ordinary knowledge in the art. The exemplary embodiments may be embodied in various forms without being limited to the exemplary embodiments set forth herein. Descriptions of well-known parts are omitted for clarity, and like reference numerals refer to like elements throughout.

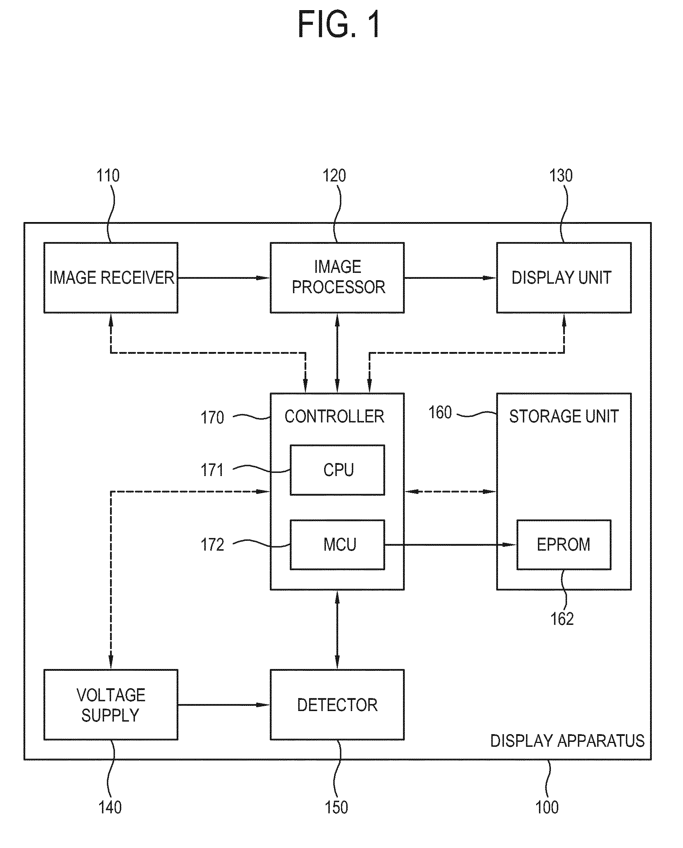

FIG. 1 is a block diagram of a display apparatus 100 according to an embodiment. As shown therein, the display apparatus 100 processes an image signal supplied by an external image supply source (not shown) according to a preset image processing operation, and displays an image based on the processed image signal.

The display apparatus 100 according to the present embodiment may be implemented as a TV which processes a broadcasting image based on broadcasting signals and/or broadcasting information and/or broadcasting data transmitted by a transmission apparatus of a broadcasting station. However, the concept of the present invention is not limited to the case where the display apparatus 100 is implemented as a TV. The display apparatus 100 may apply to various types of embodiments such as any monitor which processes an image. For example, the display apparatus 100 may apply to, a monitor of a personal computer, laptop, portable device, mobile phone, tablet, digital medial player, etc.

The type of an image which is displayable by the display apparatus 100 is not limited to the broadcasting image, and may include a video, still image, applications, an on screen display (OSD), a graphic user interface (GUI) to control various operations, based on signals and/or data transmitted by various signal supply sources (not shown). According to an embodiment, the display apparatus 100 may be implemented as a smart TV. The smart TV may receive and display a broadcasting signal in real-time, perform a web browser function and thus may display a broadcasting signal in real-time and at the same time search and consume various contents through the Internet and provide a convenient user environment. The smart TV may include an open software platform and may provide an interactive service for a user. Accordingly, the smart TV may provide various contents, e.g., an application providing a predetermined service, through the open software platform. Such an application may provide various types of services, e.g., social networking service (SNS), financial services, news, weather, maps, music, movies, games, e-books, and the like.

As shown in FIG. 1, the display apparatus 100 includes an image receiver 110 which receives an image signal, an image processor 120 which processes the image signal received through the image receiver 110, a display unit 130 which displays an image thereon based on the image signal processed by the image processor 120, a voltage supply 140 which supplies a voltage to respective elements of the display apparatus 100, a detector 150 which detects a voltage supplied to the respective elements by the voltage supply 140, a storage unit 160 which stores various data therein including a detection result of the detector 150, and a controller 170 which controls the display apparatus 100.

The image receiver 110 receives and transmits an image signal to the image processor 120, and varies depending on a standard of a received image signal or the embodiment type of the display apparatus 100. For example, the image receiver 110 may receive radio frequency (RF) signals in a wireless manner from a broadcasting station (not shown) or receive image signals in a wired manner according to standards such as composite video, component video, super or separate video (S-video), SCART, high definition multimedia interface (HDMI), digital visual interface (DVI), etc. If the image signal includes a broadcasting signal, the image receiver 110 includes a tuner to tune the broadcasting signal by channel.

The image signal may be input by an external device such as a personal computer (PC), audio/video video, Blu-ray disc player, DVD player, smart phone, tablet, or a smart pad. The image signal may result from data which are received through a network such as the Internet. In this case, the display apparatus may further include a network communication unit (not shown) to communicate through a network. The image signal may result from data which are stored in the non-volatile storage unit 150 such as a flash memory or a hard disc drive. The storage unit 150 may be provided within and/or outside the display apparatus 100. If the storage unit 150 is provided outside the display apparatus 100, the display apparatus 100 may further include a connector (not shown) to which the storage unit 150 is connected.

The image processor 120 processes an image signal according to preset various image processing operations. The image processor 120 outputs the processed image signal to the display unit 130 to display an image on the display unit 130 based on the image signal.

The image processing operation of the image processor 120 may include, but is not limited to, a decoding operation corresponding to various image formats, a de-interlacing operation, a frame refresh rate conversion, a scaling operation, a noise reduction operation for improving an image quality, a detail enhancement operation, a line scanning operation, etc. The image processor 120 may be implemented as a group of individual elements which independently perform the foregoing processes or as a system-on-chip (SoC) which integrates the foregoing functions.

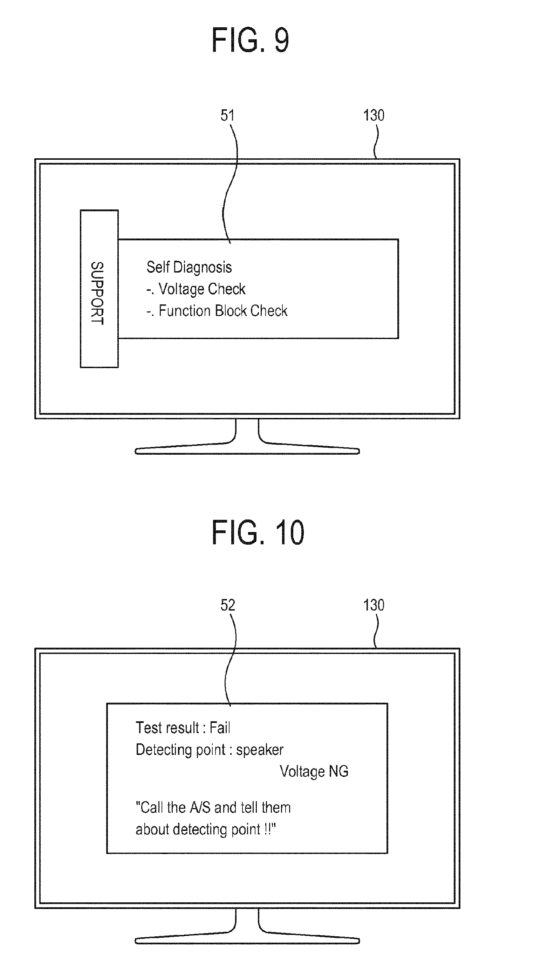

The display unit 130 displays an image thereon based on the image signal processed by the image processor 120. The display unit 130 according to the present embodiment may further display messages 51, 52 and 53 which relate to a voltage diagnosis which will be described later with reference to FIGS. 9 through 11.

The display unit 130 may be implemented as various display panels including liquid crystal, plasma, light-emitting diode (LED), organic light-emitting diode (OLED), cathode ray tube (CRT), digital light processing (DLP), surface-conduction electron-emitter, carbon nano-tube, and nano-crystal, but not limited thereto.

The display unit 130 may further include additional elements depending on its embodiment type. For example, the display unit 130 as an LCD type may include an LCD panel (not shown), a backlight unit (not shown) to emit light to the LCD panel, and a panel driving substrate (not shown) to drive the LCD panel (not shown). Further, the display unit may be embodied as a touch screen, capable of receiving an input via touch using a stylus, or direct contact from a user, for example.

The voltage supply 140 supplies a voltage to respective elements of the display apparatus 100. The voltage supply 140 converts commercial AC voltage, which is input from the outside, into a voltage to be supplied to the respective elements of the display apparatus 100. The voltage supply 140 may be implemented as a switching mode power supply (SMPS).

The detector 150 monitors a plurality of voltages supplied to respective elements of the display apparatus 100 by the voltage supply 140, and detects any error that occurs from at least one of the plurality of voltages.

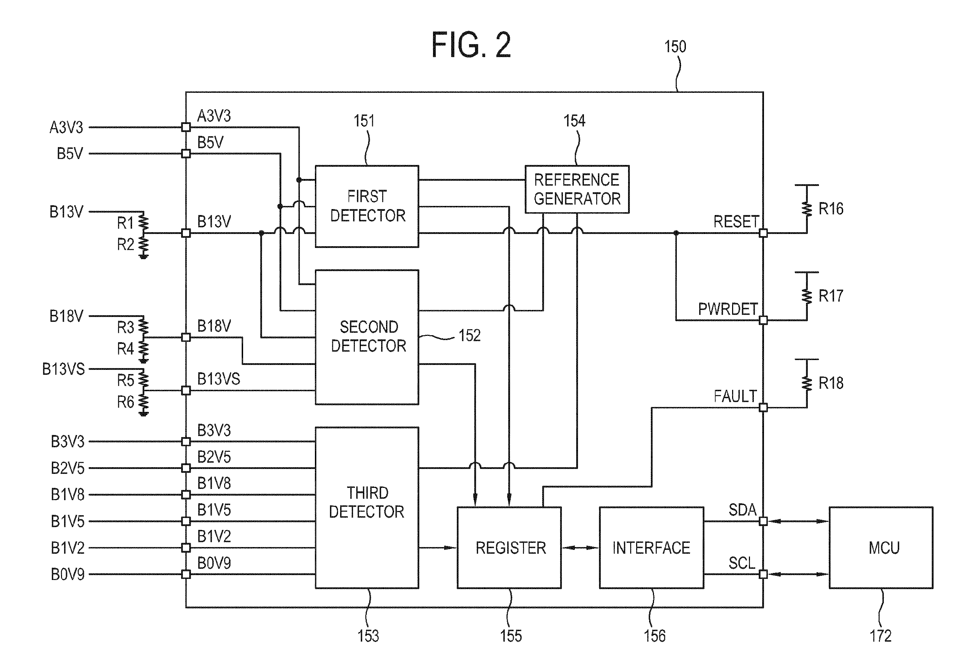

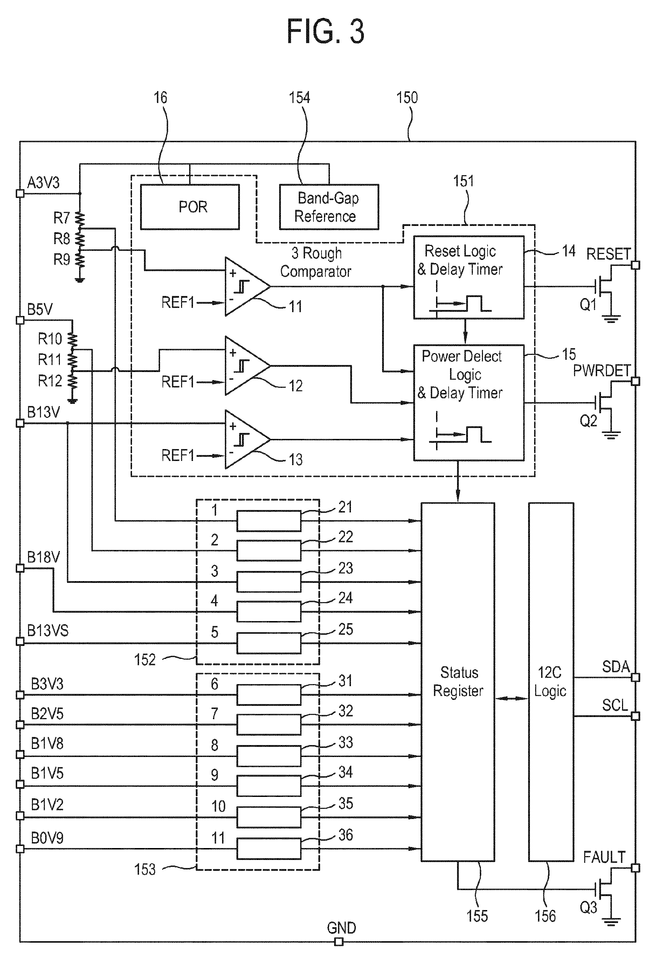

FIG. 2 is a block diagram of the detector 150 according to an embodiment. FIG. 3 is a circuit diagram of the detector 150 in FIG. 2.

As shown in FIG. 2, the detector 150 according to the present embodiment may be implemented as a single chip IC to communicate with an MCU 172 of the controller 170.

Referring to FIG. 2, the detector 150 supervises, i.e., monitors, a plurality of voltages supplied to the display apparatus 100, through first to eleventh input terminals A3V3, B5V, B13V, B18V, B13VS, B3V3, B2V5, B1V8, B1V5, B1V2 and B0V9. The first to eleventh input terminals A3V3, B5V, B13V, B18V, B13VS, B3V3, B2V5, B1V8, B1V5, B1V2, and B0V9 may correspond to and receive voltages of, e.g., 3.3V, 5V, 13V, 18V, 13V, 3.3V, 2.5V, 1.8V, 1.5V, 1.2V, and 0.9V, respectively.

The first to eleventh input terminals A3V3, B5V, B13V, B18V, B13VS, B3V3, B2V5, B1V8, B1V5, B1V2, and B0V9 may be connected to resistors (e.g., voltage-dividing resistors) R1 to R5 which are provided within and/or outside the detector 150 and divide a plurality of voltages. For example, the terminals B13V, B18V and B13VS may use external resistors R1 to R6 while the terminals A3V3, B5V, B3V3, B2V5, B1V8, B1V5, B1V2 and B0V9 may use internal resistors R7 to R15 (not shown).

Thus, the detector 150 detects the voltage divided by the resistors R1 to R15, and detects any error which occurs from at least one of the plurality of voltages according to the detection result.

As shown in FIG. 2, the detector 150 includes a first to fifth output terminals RESET, PWRDET, FAULT, SDA and SCL. The output terminals RESET and PWRDET may be connected to a first connector 151 and output reset and voltage detect signals while the output terminal FAULT may be connected to a register 155 and output a signal regarding the detection of an error. The output terminals SDA and SCL may be connected to an interface 156 and the MCU 172 and transmit signals between the detector 150 and the controller 170.

The detector 150 includes the first detector 151 which monitors an operating voltage of the display apparatus 100, second and third detectors 152 and 153 which monitor a voltage supplied to respective elements of the display apparatus 100, a reference generator 154 which generates a reference voltage supplied to the first to third detectors 151, 152 and 153, the register 155 which stores therein monitoring result data of the first to third detectors 151, 152 and 153, and the interface 156 which performs input and/or output communication with the controller 170.

The detector 150 according to the present embodiment may be set to have a preset tolerance. For example, the detector 150 may have various error tolerances such as, for example, about 5%, about 7.5% or about 10%, and a reference threshold which is input to respective comparators may be set corresponding to the preset tolerance. In the present embodiment, the detector 150 may be set to have a tolerance of 7.5% as a default, and the tolerance may be changed to 5% or 10%. The tolerance may be changed by the user using an interface, for example. Each of the respective elements of the display apparatus may have a same error tolerance, or may have different tolerances. The tolerance may individually be set by a user for each of the respective elements of the display apparatus, or the tolerance may be set by the user for all of the respective elements of the display apparatus at one time.

The detector 150 may select the error tolerance by setting an address. For example, an address xoh may correspond to 5%, x1h may correspond to 7.5% and x2h may correspond to 10%. The address x1h may be set as in a default setting. If the monitored voltage is out of the set error tolerance, the detector 150 determines that an error has occurred from the voltage and detects the error therefrom.

The first detector 151 detects power on or off status of the display apparatus 100. As shown in FIG. 3, the first detector 151 includes first to third comparators 11, 12 and 13 which receive an operating voltage according to the power on or off status of the display apparatus 100 and a first reference voltage REF1. The first detector 151 further includes first and second delay units 14 and 15 which selectively receive an output value from the first to third comparators 11, 12 and 13. The first detector 151 further includes a power on reset circuit (POR) 16 which clears the state of the MCU 172 by detecting the reset voltage upon power on of the display apparatus 100.

The first comparator 11 receives a voltage input through the input terminal A3V3 and the first reference voltage REF1, and outputs the input result to the first and second delay units 14 and 15. The first reference voltage REF1 may be about 0.2V within the set tolerance of 5%. The first reference voltage REF1 may also be set as about 1.8V within the set tolerance of 5%, and as about 2.2V within the set tolerance of 10%, for example.

The first comparator 11 operates if a voltage input is detected as a result of an abnormal comparative voltage. For example, if a voltage input from the input terminal A3V3 is detected while low is input, the first comparator 11 may output high to the first and second delay units 14 and 15.

Likewise, the second comparator 12 detects a voltage input from the input terminal B5V and outputs the detection result to the second delay unit 15. The third comparator 13 detects a voltage input from the input terminal B13V and outputs the detection result to the second delay unit 15.

The first delay unit 14 delays the output of the first comparator 11 by a preset delay time and outputs Q1 (RESET output). The second delay unit 15 delays the output of the first delay unit 14 and the first to third comparators 11, 12 and 13 by a preset delay time and outputs Q2 (PWRDET output). The delay time may be set as, for example, about 42.5ms, about 50ms and about 57.5ms. The delay time may be set as, for example, about 42.5ms, about 50ms and about 57.5ms, respectively corresponding to the set tolerance values of 5%, 7.5% and 10%.

Q1 and Q2 may be turned on and/or off by the output of the first and second delay units 14 and 15, respectively (e.g., via an active low reset output).

The output of the first delay unit 14 is input to the second delay unit 15, and the second delay unit 15 delays and outputs to the register 155 the signal input by the first delay unit 14 and the first to third comparators 11, 12 and 13. That is, the second delay unit 15 detects the voltage input of the input terminals A3V3, B5V and B13V, delays the voltage input by a predetermined delay time and then outputs the voltage input to the register 155.

As a result, in the case of the reset output, the sequence of the output of the first comparator 11 is adjusted by the first delay unit 15 for output, and in the case of the power detect output, all of the first to third comparators 11, 12 and 13 are turned on, upon reception of a voltage, and enable the detector 150.

Accordingly, in the present embodiment, the first detector 151 detects a reset voltage upon power on of the display apparatus 100, and the second and third detectors 152 and 153 may monitor a plurality of voltages if an operating voltage is normally supplied (e.g., if the display apparatus 100 operates in a normal mode). The reset voltage may be about 1.6V.

The first detector 151 detects the power on through the first to third comparators 11, 12 and 13 and outputs high to the register 155 to reset the value stored in the register 155.

The POR 16 detects the input of the reset voltage (about 1.6V) and clears the state of the MCU 172 (to be described later). The MCU 172 may receive the clearing command from the POR 16 and read the value stored in the register 155 through the interface 156 to monitor the voltage.

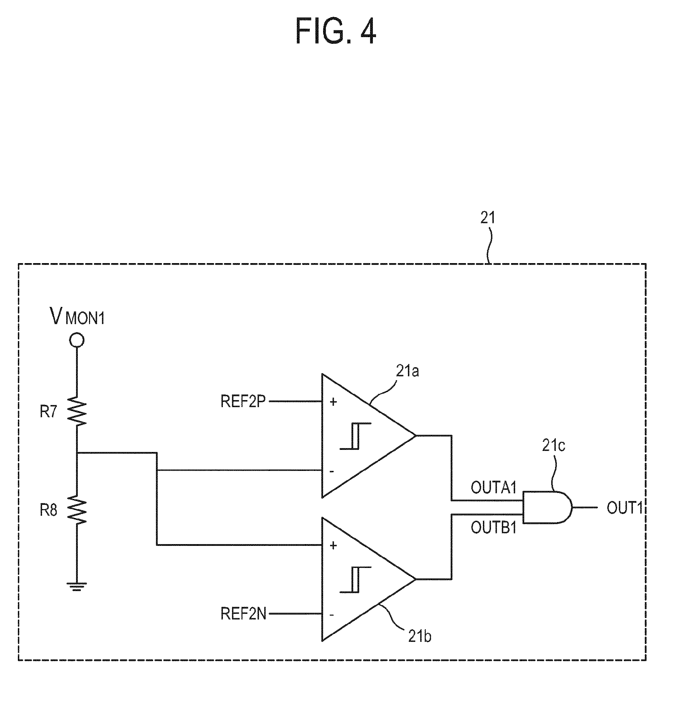

As shown in FIG. 3, the second detector 152 includes fourth to eighth comparators 21, 22, 23, 24 and 25 which receive an input voltage of first to fifth input terminals A3V3, B5V, B13V, B18V and B13VS of the display apparatus 100 and a second over reference voltage REF2P and a second under reference voltage REF2N. Second over reference voltage REF2P and second under reference voltage REF2N are further discussed with reference to FIG. 4.

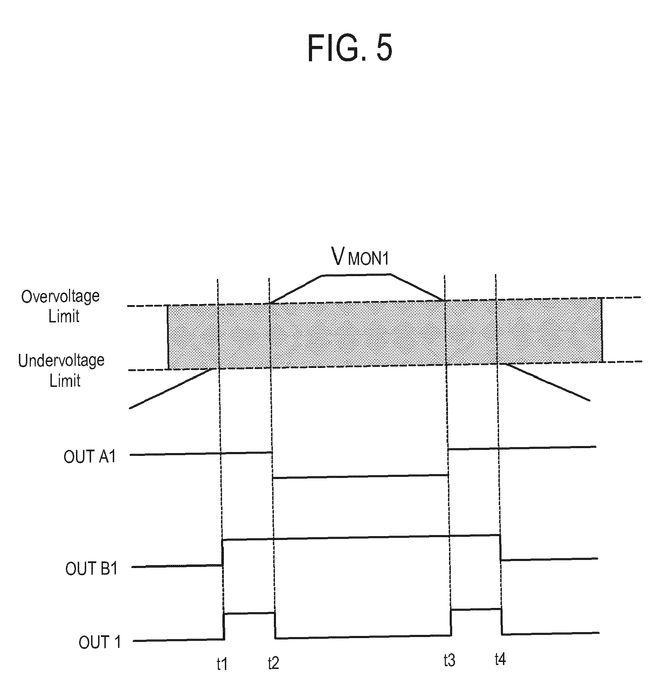

FIG. 4 is a circuit diagram of the fourth comparator 21 according to an embodiment. FIG. 5 illustrates waveforms of an input and output signals of the fourth comparator 21.

FIGS. 4 and 5 illustrate the circuit diagram and waveforms of the fourth comparator 21 for purposes of convenience, and the circuit diagram and waveforms may also apply to the fifth to eighth comparators 22, 23, 24 and 25.

The fourth comparator 21 includes a comparator 21a which compares an input voltage V_{MON1} input by the input terminal A3V3 and a second over reference voltage REF2P, a comparator 21b which compares the input voltage V_{MON1} and a second under reference voltage REF2N, and an AND gate 21c which receives an output value OUTA1 of the comparator 21a and an output value OUTB1 of the comparator 21b. The input voltage V_{MON1} may be an input voltage of the input terminal A3V3, divided by the resistors R7 and R8 and input to the comparators 21a and 21b.

In the example embodiment, if the tolerance is about 7.5%, the second over reference voltage REF2P may be about 1.075V and the second under reference voltage REF2N may be about 0.925V. The second over reference voltage REF2P may be set as about 1.05V within the tolerance of 5%, and as about 2.0V within the tolerance of 10%. The second under reference voltage REF2N may be set as about 0.9V within the tolerance of 5% and as about 0.95V within the tolerance of 10%.

Referring to FIG. 5, if the input voltage V_{MON1} is lower than the second over reference voltage REF2P, the comparator 21a maintains a high state. If the input voltage V_{MON1} is equal to the second over reference voltage REF2P or more, the comparator 21a outputs a low. If the input voltage V_{MON1} is equal to the second under reference voltage REF2N or more, the comparator 21b maintains a high state. If the input voltage V_{MON1} is lower than the second under reference voltage REF2N, the comparator 21b outputs a low.

The AND gate 21c outputs a high only when the output values OUTA1 and OUTB1 of the comparators 21a and 21b are high. More specifically, if the input voltage _{VMON1} is within a proper range from the second under reference voltage REF2N and the second over reference voltage REF2P, then the AND gate 21c outputs a high. As can be seen from the example embodiment of FIG. 5, the AND gate 21c outputs a high from the t1-t2 period and from the t3-t4 period, and outputs a low during the other periods. Accordingly, the fourth comparator 21 outputs a low as the output value OUT1 if a voltage error occurs. That is, an error may be determined when the input voltage _{VMON1} is not within a proper range, i.e., when the input voltage _{VMON1} is less than the undervoltage limit, or exceeds the overvoltage limit.

The fifth to eighth comparators 22, 23, 24 and 25 also output a low if an error occurs from the input voltage. The second over reference voltage REF2P and the second under reference voltage REF2N of the fifth to eighth comparators 22, 23, 24 and 25 may be set to be different from those of the fourth comparator 21.

For example, in the display apparatus 100 according to the present embodiment, a low noise block down converter (LNB) voltage may be input to the input terminal B18V. The LNB voltage may be a minimum of 11.5V and a maximum of 11.5V, and may be divided by the resistors R3 and R4 to be in the range of 0.7 to 1.3V, and may be input to the comparators 21a and 21b.

If the tolerance is 7.5%, the second under reference voltage REF2N of the seventh comparator 24 receiving the LNB voltage may be set as 0.7*0.925=0.65V, and the over reference voltage REF2P may be set as 1.3*1.075=1.4V.

As shown in FIG. 3, the third detector 153 includes ninth to fourteenth comparators 31, 32, 33, 34, 35 and 36 which receive input voltages of the sixth to eleventh input terminals B3V3, B2V5, B1V8, B1V5, B1V2 and B0V9 of the display apparatus 100 and a third reference voltage REF3.

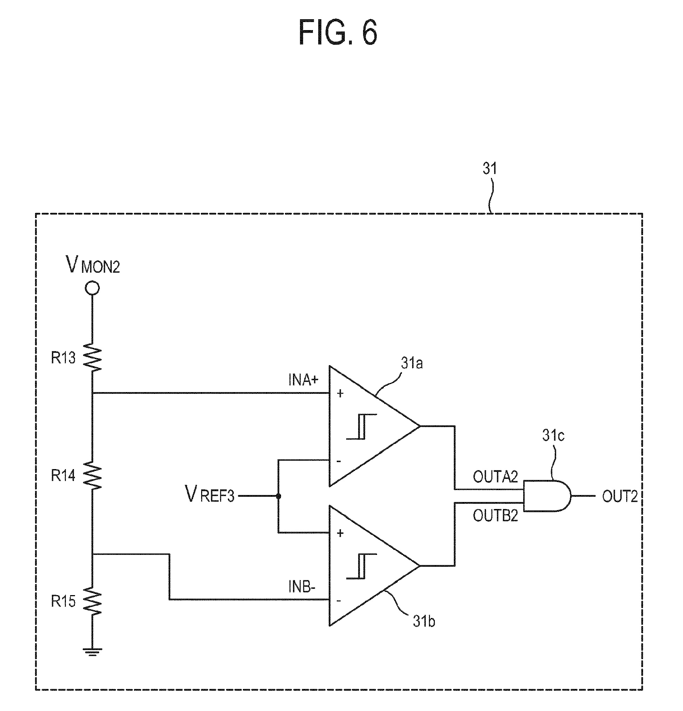

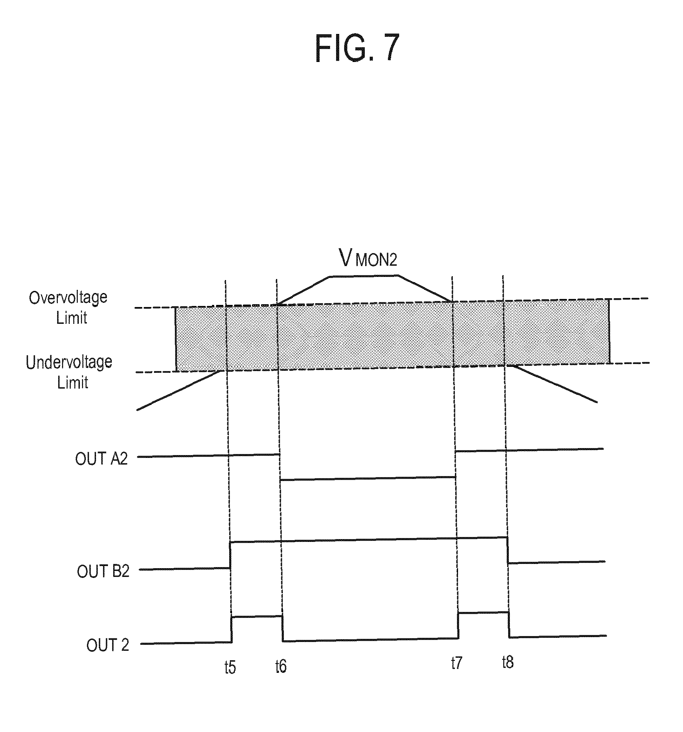

FIG. 6 is a circuit diagram of the ninth comparator 31 according to an embodiment. FIG. 7 illustrates waveforms of an input and output signals of the ninth comparator 31.

FIGS. 6 and 7 illustrate only the circuit diagram and waveforms of the ninth comparator 31 for purposes of convenience, and the circuit diagram and waveforms may equally apply to the tenth to fourteenth comparators 32, 33, 34, 35 and 36.

The ninth comparator 31 includes comparators 31a and 31b which compare an input voltage V_{MON2} input by the input terminal B3V3 and the third reference voltage REF3, and an AND gate 31c which receives an output value OUTA2 of the comparator 31a and an output value OUTB2 of the comparator 31b. The input voltage V_{MON2} may be an input voltage of the input terminal B3V3, and INA+ and INB- which are divided by the resistors R13, R14 and R15 are input to the comparators 31a and 31b, respectively.

If the tolerance is set to 7.5% in the present embodiment, the third reference voltage REF3 may be about 0.8V. If the tolerance is set to 5%, the third reference voltage REF3 may be set as about 0.789V. If the tolerance is set to 10%, the third reference voltage REF3 may be set as about 0.82V.

Referring to FIG. 7, if the input voltage INA+ is lower than the third reference voltage REF3, the comparator 31a outputs a low. If the input voltage INA+ is equal to the third reference voltage REF3 or more, the comparator 31a outputs a high. If the input voltage INB- is equal to the third reference voltage REF3 or more, the comparator 31b outputs a low. If the input voltage INB- is lower than the third reference voltage REF3, the comparator 31b outputs a high+-.

The AND gate 31c outputs a high only when the output values OUTA2 and OUTB2 of the comparators 31a and 31b are all high. More specifically, if INA+ is equal to the third reference voltage REF3 or more and INB- is lower than the third reference voltage REF3 as in FIG. 7, i.e., during the t5-t6 period and the t7-t8 period, the AND gate 31c outputs a high, and during other periods, the AND gate 31c outputs a low. Accordingly, the ninth comparator 31 outputs a low as the output value OUT2 if a voltage error occurs. That is, an error may be determined when the input voltage _{VMON2} is not within a proper range, i.e., when the input voltage _{VMON2} is less than the undervoltage limit, or exceeds the overvoltage limit.

The tenth to fourteenth comparators 32, 33, 34, 35 and 36 also output a low if an error occurs from the input voltage. The third reference voltage REF3 of the tenth to fourteenth comparators 32, 33, 34, 35 and 36 may be set to be different from that of the ninth comparator 31.

As illustrated in FIGS. 4 to 7, upon occurrence of an error, the comparators 21, 22, 23, 24, 25, 31, 32, 33, 34, 35 and 36 of the second and third detectors 152 and 153 output a low, and the output values OUT1 and OUT2 are stored in the register 155.

The reference generator 154 generates the second reference voltage REF1, the second over reference voltage REF2P, the second under reference voltage REF2N and the third reference voltage REF3 supplied to the first to third detectors 151 to 153, and supplies the voltages to the comparators 11-13, 21-25, and 31-36.

The register 155 stores therein the output value of the first to third detectors 151 to 153. More specifically, the first detector 151 detects power-on of the display apparatus 100 and resets the data stored in the register 155. After the reset, the output values of the second and third detectors 152 and 153 may be stored in the register 155 according to the voltage monitoring. Upon occurrence of an error from at least one of the plurality of input voltages which are input by the input terminals A3V3, B5V, B13V, B18V, B13VS, B3V3, B2V5, B1V8, B1V5, B1V2 and B0V9, a low may be stored in the register 155. The register 155 according to the present embodiment may be implemented as a state register which stores a state value of low or high. Q3 operates to be turned on or off depending on the output by the register 155.

The register 155 according to the present embodiment is cleared at the time when the voltage diagnosis is begun, and stores result data according to the voltage diagnosis. The stored result data are maintained until a next voltage diagnosis is performed.

The interface 156 is used to connect the register 155 and the MCU 172 by a control of the MCU 172 (to be described later). The interface 156 as an I/O interface communicating with peripheral elements may use an Inter-Integrated Circuit (I2C) communication protocol.

The storage unit 160 stores therein unlimited data by a control of the controller 170. The data which are stored in the storage unit 160 may include an operating system (OS) for driving the display apparatus 100, various applications which are executed on the OS, image data, and additional data.

The storage unit 150 is accessed by the controller 170, and data stored therein may be read and/or written and/or modified and/or deleted and/or updated by the controller 170.

The storage unit 150 may be implemented as a non-volatile storage medium such as a flash memory or a hard disc drive. The storage unit 160 according to an embodiment may further include an erasable programmable read only memory (EPROM) 162 which stores therein a monitoring result for a plurality of voltages by a control of the MCU 172.

The controller 170 performs control operations for various elements of the display apparatus 100. For example, the controller 170 controls the image processor 120 to process an image signal, and performs a control operation in response to a command of a remote controller to thereby control overall operations of the display apparatus 100.

The controller 170 may be implemented as a CPU 171 into which software may be integrated. The controller 170 according to an embodiment may further include the micro control unit (MCU) 172 which reads data from the register 155 of the detector 150 and writes the data in the EPROM 162. The MCU 172 may be implemented as a sub micom which assists the CPU 171.

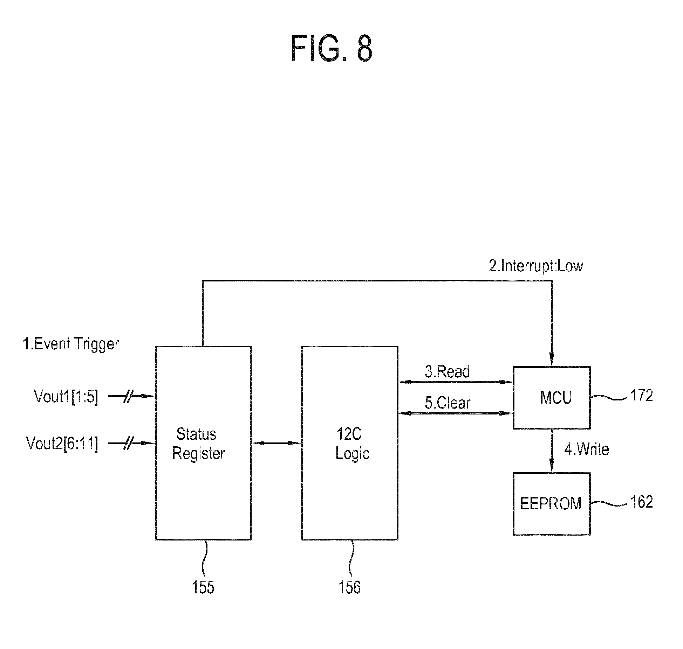

FIG. 8 illustrates an error detection operation according to an embodiment.

As shown therein, the detector 150 monitors a plurality of voltages supplied to respective elements of the display apparatus 100 through the fourth to eighth comparators 21 to 25 of the second detector 152 and the ninth to fourteenth comparators 31 to 36 of the third detector 153. For example, the fourth to eighth comparators 21 to 25 of the second detector 152 may be used to monitor voltages of the elements of the display apparatus 100 corresponding to a plurality of input terminals (e.g., first to fifth input terminals A3V3, B5V, B13V, B18V, B13VS), and to output an output value OUT1 to the status register 155. Likewise, the ninth to fourteenth comparators 31 to 36 of the third detector 153 may be used to monitor voltages of the elements of the display apparatus 100 corresponding to a plurality of input terminals (e.g., sixth to eleventh input terminals B3V3, B2V5, B1V8, B1V5, B1V2 and B0V9), and to output an output value OUT2 to the status register 155.

The detector 150 may monitor the voltages corresponding to an occurrence of an event trigger by a control of the controller 170. For example, the display apparatus 100 according to the present embodiment may monitor the voltages when (e.g., during the time) the display apparatus 100 is powered on or when a user selects the voltage diagnosis menu (e.g., in response to a user selecting the voltage diagnosis menu via an interface which communicates with the display apparatus 100).

The result of the voltage diagnosis by the detector 150 (e.g., output values OUT1 and/or OUT2) is stored in the register 155. The stored result of the voltage diagnosis may be indicated as high or low for each input terminal, and may include an address of the input terminal. The address may be logically provided in any format (e.g., binary, hexadecimal, decimal, etc.).

The MCU 172 reads data from the register 155 through the interface 156, and writes the data in the EPROM 162. The data stored in the register 155 may be cleared by the interface 156 by a control of the MCU 172 at the time when a next voltage monitoring is begun.

The controller 170 may determine a location where the error has occurred among the elements of the display apparatus 100 by using the value written in the EPROM 162.

The storage unit 160 according to an embodiment may store therein a table showing the elements of the display apparatus 100 corresponding to the plurality of input terminals (e.g., first to eleventh input terminals A3V3, B5V, B13V, B18V, B13VS, B3V3, B2V5, B1V8, B1V5, B1V2 and B0V9). For example, the input voltage of the input terminal B18V may correspond to the LNB voltage, the input voltage of the input terminal B13VS may correspond to a speaker voltage and the input voltage of the input terminal B5V may correspond to a USB voltage. However, the disclosure is not so limited and other elements may correspond to the respective input terminals.

FIG. 9 illustrates a screen for setting a voltage diagnosis menu according to an embodiment. FIG. 10 illustrates an example of a message showing a voltage diagnosis result according to an embodiment.

As shown in FIG. 9, a user may manipulate a user input unit such as a remote controller to select a voltage diagnosis (self diagnosis test) menu 51 from a screen 130 of the display apparatus 100. However, the disclosure is not limited to the above-described example embodiment. For example, the user may select a voltage diagnosis (self diagnosis test) menu 51 by other methods (e.g., via a touch screen, by voice command, through physical buttons, or by using other types of input devices such as a mouse, trackball, stylus, and the like).

If a user selects the voltage diagnosis menu 51, the controller 170 compares the data written in the EPROM 162 with the table stored in the storage unit 160, and determines a location where the voltage error has occurred. The controller 170 controls the display unit 130 to display thereon a message showing the voltage error in the form of an on screen demand (OSD) according to the determination result as in FIG. 10.

As shown in FIG. 10, the displayed voltage diagnosis result message 52 may include occurrence and/or the non-occurrence of a voltage error according to the test, the location of the error and necessity of A/S. For example, the diagnosis result message 52 shows "fail" and the location of the error, i.e., the speaker if the error which has occurred from the input terminal B13VS is detected. In the same manner, if the error which has occurred from the input terminal B5V is detected, the display unit 130 may display thereon a message showing the location of the error, i.e., the USB. However, the disclosure is not limited to the above-described example embodiment. For example, the diagnosis result message 52 may show the status of all input terminals whether or not an error has been detected in one of the input terminals. Alternatively, if there is no error present then no diagnosis result message may be displayed, or a message indicating no errors detected may simply be shown. Further, if there are multiple errors, the diagnosis result message may show the multiple errors and their corresponding locations at one time on the screen of the display apparatus. Alternatively, the multiple errors and their corresponding locations may separately be displayed on different pages or screens by which the user may scroll to or switch to, as necessary. However, in such a case it may be advantageous to provide an indication to the user that errors other than an error currently being displayed are present.

Menus of the display apparatus 100 may be manipulated by a user's selection to periodically perform a voltage diagnosis, and the controller 170 may monitor the power diagnosis if the set diagnosis period arrives. That is, the controller 170 may perform a voltage diagnosis at preset time periods according to the schedule input by a user, or according to a default setting, for example.

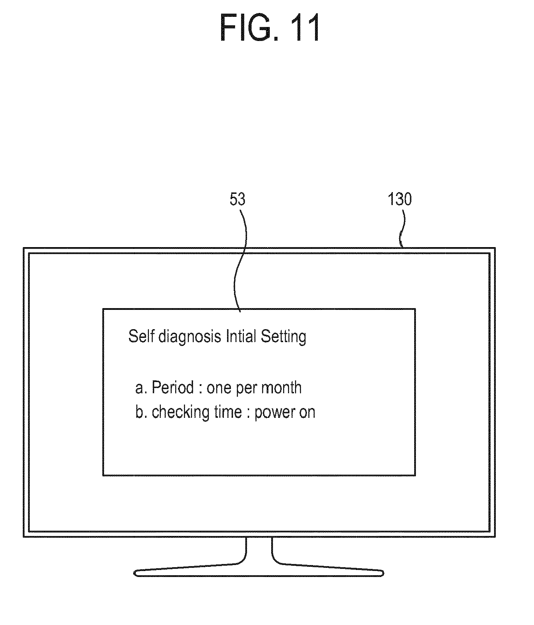

FIG. 11 illustrates a screen for setting periodical performance of the voltage diagnosis according to an embodiment.

A user may select the periodical performance of the voltage diagnosis through the user input unit. For example, a user may set the power diagnosis to be performed every month as in FIG. 11 and set the power diagnosis to be performed when the display apparatus 100 is powered on. However, the disclosure is not limited to the above-described example embodiment. For example, the power diagnosis may be performed during other periods (e.g., hourly, daily, weekly, and/or at a specific time of day, etc.). Further, the self-diagnosis may have an initial or default setting.

Then, if the set period arrives or the display apparatus 100 is powered on, the controller 170 performs the voltage diagnosis. If the voltage diagnosis is begun, the MCU 172 applies a reset voltage to clear the detector 150. The detector 150 monitors a plurality of voltages through the first to eleventh input terminals A3V3, B5V, B13V, B18V, B13VS, B3V3, B2V5, B1V8, B1V5, B1V2 and B0V9 and detects an error which occurs from at least one of the plurality of voltages.

The monitoring result is stored in the register 155, and the MCU 172 reads the result data of the register 155 through the interface 156 and writes the data in the EPROM 162.

The controller 170 checks the data written in the EPROM 162, determines the location where the error has occurred, and displays the location on the display unit 130.

Hereinafter, a control method of the display apparatus 100 according to the present embodiment will be described with reference to drawings.

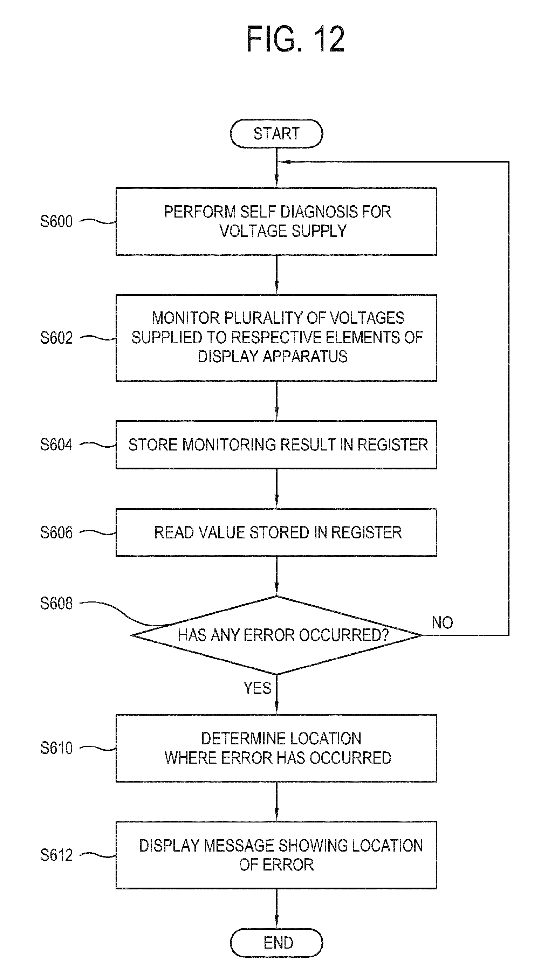

FIG. 12 illustrates a method of detecting an error from a voltage of the display apparatus 100 according to an embodiment.

As shown therein, the display apparatus 100 may begin the self diagnosis with respect to the voltage supplied to respective elements of the display apparatus 100 (S600). The controller 170 may begin the voltage diagnosis if at least one of the following conditions is satisfied: an input of a test command by a user through the selection of the voltage diagnosis menu 51; the arrival of the preset voltage diagnosis period; and the power-on of the display apparatus 100. However, the disclosure is not so limited. Other events may cause the voltage diagnosis to be performed, and the above-described conditions are not intended to be limiting. The MCU 172 may reset, i.e., clear an integrated circuit (IC) of the detector 150 upon beginning of the voltage diagnosis.

If the voltage diagnosis is begun at operation S600, the controller 170 monitors the plurality of voltages supplied to the respective elements of the display apparatus 100 (S602). More specifically, the second and third comparators 152 and 153 of the detector 150 may detect an error occurring from the plurality of voltages by comparing the voltage input through the first to ninth input terminals A3V3, B5V, B13V, B18V, B13VS, B3V3, B2V5, B1V8, B1V5, B1V2 and B0V9 with a preset reference voltage. The monitoring result which has been obtained at operation S602 may be stored in the register 155 (S604). As new monitoring result data are stored in the register 155, the existing data may be reset. For example, the existing data may be overwritten by the new monitoring result data obtained at operation S602, the existing data may be deleted, or an address or value corresponding to the existing data may be set to all zeroes.

The MCU 172 reads the result value stored in the register 155 during operation S604 (S606). The MCU 172 may read the data stored in the register 155 through the interface 156, and the read result value may be written in the EPROM 162.

According to the result value read at operation S606, the controller 170 determines whether any error has occurred from the voltages supplied to the respective elements of the display apparatus 100 (S608).

If it is determined that the error has occurred at operation S608, the controller 170 determines the location where the voltage error has occurred (S610). The controller 160 may determine such occurrence of the error by identifying the elements of the display apparatus 100 which output low as the input voltage as determined at operation S602 among the first to eleventh input terminals A3V3, B5V, B13V, B18V, B13VS, B3V3, B2V5, B1V8, B1V5, B1V2 and B0V9.

The controller 170 controls the display unit 130 to display a message 52 showing the location where the voltage error has occurred, according to the determination result obtained at operation S610 (S612).

According to the above-disclosed example embodiments, the display apparatus 100 may include a circuit which is configured, adapted, or capable of performing the self diagnosis with respect to the voltage applied to various elements included in the display apparatus through the built-in IC of the detector 150. Thus, the display apparatus 100 having the circuit may check the occurrence and/or non-occurrence of a voltage error without difficulty.

A user may simply select the voltage self diagnosis menu to identify the occurrence and/or non-occurrence of the voltage error and the location where the error has occurred. Accordingly, the location of the error is easily identified at the time of A/S, saving time and costs.

Further, the voltage self diagnosis may be performed periodically to improve safety and reliability of operations of the display apparatus 100.

The display apparatus and method for detecting a voltage error thereof according to the above-described example embodiments may use one or more processors, which may include a microprocessor, central processing unit (CPU), digital signal processor (DSP), or application-specific integrated circuit (ASIC), as well as portions or combinations of these and other processing devices.

The method for detecting a voltage error in a display apparatus according to the above-described embodiments may be recorded in non-transitory computer-readable media including program instructions to implement various operations embodied by a computer. The media may also include, alone or in combination with the program instructions, data files, data structures, and the like. Examples of non-transitory computer-readable media include magnetic media such as hard disks, floppy disks, and magnetic tape; optical media such as CD ROM discs and DVDS; magneto-optical media such as optical discs; and hardware devices that are specially configured to store and perform program instructions, such as read-only memory (ROM), random access memory (RAM), flash memory, and the like. Examples of program instructions include both machine code, such as produced by a compiler, and files containing higher level code that may be executed by the computer using an interpreter. The described hardware devices may be configured to act as one or more software modules that are recorded, stored, or fixed in one or more computer-readable storage media, in order to perform the operations of the above-described embodiments, or vice versa. The program instructions may be executed by one or more processors. In addition, a non-transitory computer-readable storage medium may be distributed among computer systems connected through a network and computer-readable codes or program instructions may be stored and executed in a decentralized manner. In addition, the computer-readable storage media may also be embodied in at least one application specific integrated circuit (ASIC) or Field Programmable Gate Array (FPGA).

Although a few exemplary embodiments have been shown and described, it will be appreciated by those skilled in the art that changes may be made to these exemplary embodiments without departing from the principles of the invention, the range of which is defined in the appended claims.

## Claims

1. A display apparatus comprising:
a display unit which displays an image;
a voltage supply which supplies a voltage to elements of the display apparatus;
a detector which monitors a plurality of voltages supplied to the elements of the display apparatus and detects an error according to at least one of the plurality of voltages; and
a controller which determines a location where an error has occurred according to a detection result of the detector.

2. The display apparatus according to claim 1, wherein the controller controls the display unit to display a message showing the location where the voltage error has occurred.

3. The display apparatus according to claim 1, further comprising a plurality of resistors connected to the plurality of voltages and divides the voltages.

4. The display apparatus according to any one of the preceding claims, wherein the detector comprises a first detector which detects a power status of the display apparatus.

5. The display apparatus according to claim 4, wherein the first detector comprises:
a plurality of comparators which receives an operating voltage according to the power status and a first reference voltage; and
a plurality of delay units which selectively receives an output value of the plurality of comparators.

6. The display apparatus according to claim 3, wherein the detector comprises second and third detectors which compare the plurality of voltages with a preset reference voltage and detect a voltage error according to at least one of the plurality of voltages.

7. The display apparatus according to claim 6, wherein the second detector comprises a plurality of comparators which determines whether an input voltage is within a preset range, and the plurality of comparators comprises a first comparator which receives one of the plurality of voltages and a second over reference voltage, and outputs a comparison result, and a second comparator which receives one of the plurality of voltages and a second under reference voltage and outputs a comparison result.

8. The display apparatus according to claim 6 or 7, wherein the third detector comprises a plurality of comparators which determines whether an input voltage is within a preset range, and the plurality of comparators comprises a third comparator which receives one of the plurality of divided voltages and a third reference voltage, and outputs a comparison result, and a fourth comparator which receives one of the plurality of divided voltages and the third reference voltage and outputs a comparison result.

9. The display apparatus according to one of claims 1 to 8, wherein the monitoring of the plurality of voltages is performed if at least one of a user's input for selecting a self-diagnosis of voltages, arrival of a preset diagnosis period, and a power-on of the display apparatus, is satisfied.

10. A method of detecting a voltage error of a display apparatus comprising:
monitoring a plurality of voltages supplied by a voltage supply to elements of the display apparatus;
detecting a voltage error according to at least one of the plurality of voltages; and
determining a location where the voltage error has occurred according to the detection result.

11. The method according to claim 10, further comprising displaying a message showing the location where the voltage error has occurred.

12. The method according to claim 10 or 11, wherein the detecting the error comprises:
comparing the plurality of voltages with a preset reference voltage; and
detecting whether a voltage error occurs according to the comparison result.

13. The method according to claim 12, wherein the comparing comprises determining whether the input voltage is within a preset range.

14. The method according to any one of claims 10 to 13, further comprising:
storing data according to a monitoring result of the plurality of voltage; and
resetting stored monitoring result data before the monitoring is begun.

15. The method according to one of claims 10 to 14, wherein the monitoring is performed in response to a user's input for selecting a self-diagnosis of voltages, arrival of a preset diagnosis period, or a power-on of the display apparatus is satisfied.
